# EUROPEAN PATENT APPLICATION

(11) **EP 0 792 095 A2**
(43) Date of publication of application: **27.08.1997**
(21) Application number: 97102652.1
(22) Date of filing: 19.02.1997
(51) Int. Cl.: H05K 5/06

(54) **Seals for tight-seal box**

(30) Priority: 20.02.1996 IT MI960126 U
(71) Applicant: ABB Lucasystem S.r.L., 20137 Milano (IT)
(72) Inventor: Pezzato, Maurizio, 36067 San Giuseppe - Cassola, (Vicenza) (IT)
(74) Representative: Gervasi, Gemma, Dr.

(57) **Abstract**

A one-piece seal (1) is described which is scarried by the lid, or by the body, of a tight-seal box, which comprises basically circular protruding areas (3), each of which is positioned over one of the fixing bodies (4) (belonging to the lid or else to the body of the box), inside which holes (5) are made for screws fastening the lid to the body of the box. Each protruding area (3) is housed in a sunken area (6) made at the end of the corresponding fixing body (4).

There is moreover described a method for making simultaneously the lid (or the body) of a tight-seal box and a one-piece seal (1) carried by the lid, or by the body, of the tight-seal box.

The seal (1), the body and the lid of the box are made of plastic material and are made by moulding.

## Description

### Field of invention

The invention consists of a one-piece seal carried by the lid, or by the body, of a tight-seal box, which comprises basically circular protruding areas, which are positioned over bodies having a generally cylindrical shape (hereinafter referred to as "fixing bodies") belonging to the lid (or to the body of the box), inside which holes are made for screws fastening the lid to the body of the box.

The invention moreover consists of a method for making simultaneously the lid (or the body) of a tight-seal box and a one-piece seal carried by the lid, or by the body, of the tight-seal box.

Preferably, but not necessarily, the seal, the body and the lid of the box are made of plastic material and are made by moulding.

### Prior art

For some time now, tight-seal boxes consisting of a body and of a lid assembled by means of fixing screws have been well-known and widely available on the market. These boxes are normally used in a large number of technological fields, for example as connector blocks for electric systems.

The above tight-seal boxes comprise a seal (made of rubber or of a functionally equivalent material), which is carried by the lid or by the body of the box, from which it may protrude at least partially. Tight-sealing of the box is obtained by tightening the lid and the body of the box together through fixing screws set in holes made in the fixing bodies.

Very frequently, the seal is set in a groove made around the rim of the lid, or else around the rim of the top of the body of the tight-seal box.

It has been found that inserting the seal in the groove and fixing it there is not always a simple or economic operation: it may in fact happen that the seal (for example, because it is inserted and/or fixed in the groove in an incorrect way) comes out of the groove, thus jeopardizing the reliability of the tight-seal box. To overcome this problem, the present invention provides a method for making the seal at the same time as the lid (or the body) of the tight-seal box, or anyway during the same manufacturing step.

It has moreover been found that the boxes of known type are not able to guarantee a tight seal in all environmental conditions, in particular if they are installed in a damp environment and/or out of doors, where they are exposed to the weather. In fact, the fixing bodies are normally set inside the seal, and consequently the holes in which the fixing screws are set are (or may be) critical points for the tight sealing of the box, since water and/or moisture may filter or seep along the fixing screws and/or the corresponding holes, and infiltrate into the box, so "finding a way round" the seal.

This is a further (at least potentially) serious drawback which adversely affects the reliability of tight-seal boxes of the known type and which limits (or may limit) considerably the possibility of using these boxes in an efficient way.

To overcome this (at least potentially) serious additional drawback and guarantee tightness of the box also at the fixing screws, the Applicant has made a one-piece seal (made preferably according to the aforementioned method) comprising protruding areas, each of which is set above one of the fixing bodies and is housed in a sunken area made at the end of said fixing body.

### Summary of invention

The present invention consists of a one-piece seal for a tight-seal box, comprising a lid fixed to the body of the box by means of screws set in holes in fixing bodies belonging to the lid, or to the body of the box. At each fixing body, the seal (positioned in a groove made around the rim of the lid, or of the body of the box) comprises a protruding area which is positioned over the fixing body and is housed in a sunken area made at the end of the fixing body.

The present invention also consists of a method for making simultaneously the lid, or the body, of a tight-seal box and a one-piece seal carried by the lid, or by the body, of the tight-seal box.

### List of figures

The invention will be better described with reference to a non-limiting embodiment shown in the attached figures, where:
- Figure 1 shows a bottom view of a lid carrying a seal according to the invention;
- Figures 2 and 3 show partial sectional views of the lid of Fig. 1, made along the plane A-A, or the plane B-B;
- Figure 4 shows an enlarged view of the detail P of the lid of Fig. 1;
- Figure 5 is a schematic cross sectional view of a mould for making the lid of a tight-seal box;
- Figure 6 is a schematic view of the mould of Fig. 5 prepared for realising the seal.

In the attached figures, the corresponding elements will be identified by means of the same reference numbers.

### Detailed description

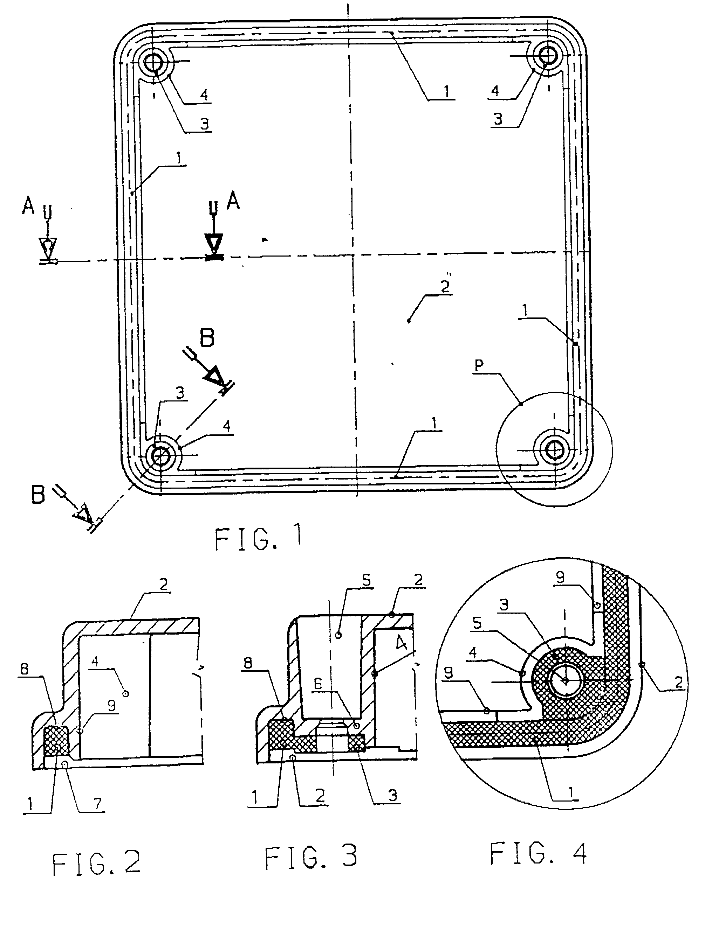

Figure 1 shows a bottom view of a lid 2 of a tight-seal box, where are shown: the fixing bodies 4 and the seal 1 (comprising the protruding areas 3, which have a substantially circular shape), positioned in a groove 7 (which is shown in Figures 2 and 3, but it is not shown in Figures 1 and 4 because it is occupied by the seal 1 ) made around the rim of the lid 2. Preferably, but not necessarily, the lid 2 and the body of the box (not illustrated in the figures) are made of plastic material and are made by moulding.

The protruding areas 3 belonging to the seal 1 (which can be better seen in Figures 3 and 4) are positioned over the fixing bodies 4, inside which are set the screws (set in the holes 5 made in the fixing bodies 4 and not shown in the figures), which fasten the lid 2 to the body of the box.

Each of the protruding areas 3 of the seal 1 is housed in a sunken area 6 (Fig. 3) made at the end of the corresponding fixing body 4 to prevent any water and/or moisture seeping of filtering along the fixing screw and/or through the corresponding hole 5 made in the fixing body 4 from infiltrating inside the box, thus "finding a way round" the seal 1.

In the present embodiment (Fig. 3) the sunken areas 6 made at the end of the fixing bodies 4 are not coplanar to the bottom 8 of the groove 7 (Figs. 2 and 3). Without departing from the scope of the invention, it is possible to make the sunken areas 6 in such a way that they are coplanar to the bottom 8 of the groove 7.

At each of the fixing bodies 4, the internal wall 9 of the groove 7 (Figs. 2 and 3) presents a discontinuity (which cannot be seen in Figs. 1 and 4 because it is hidden by the corresponding protruding area 3), which allows the seal 1 to "come out" of the groove 7 to set itself over the fixing body 4. Preferably the discontinuities have the same length and are symmetrical with respect to the corresponding fixing body 4.

The seal 1 has been described with reference to the embodiment shown in the attached figures, where the seal 1 is positioned in a groove 7 made around the rim of the lid 2, and the protruding areas 3 of the seal 1 have a basically circular shape; however, without departing from the scope of the invention, the seal may be positioned in a groove made around the rim of the top of the body of the box, and/or the protruding areas 3 may have a shape other than the circular one.

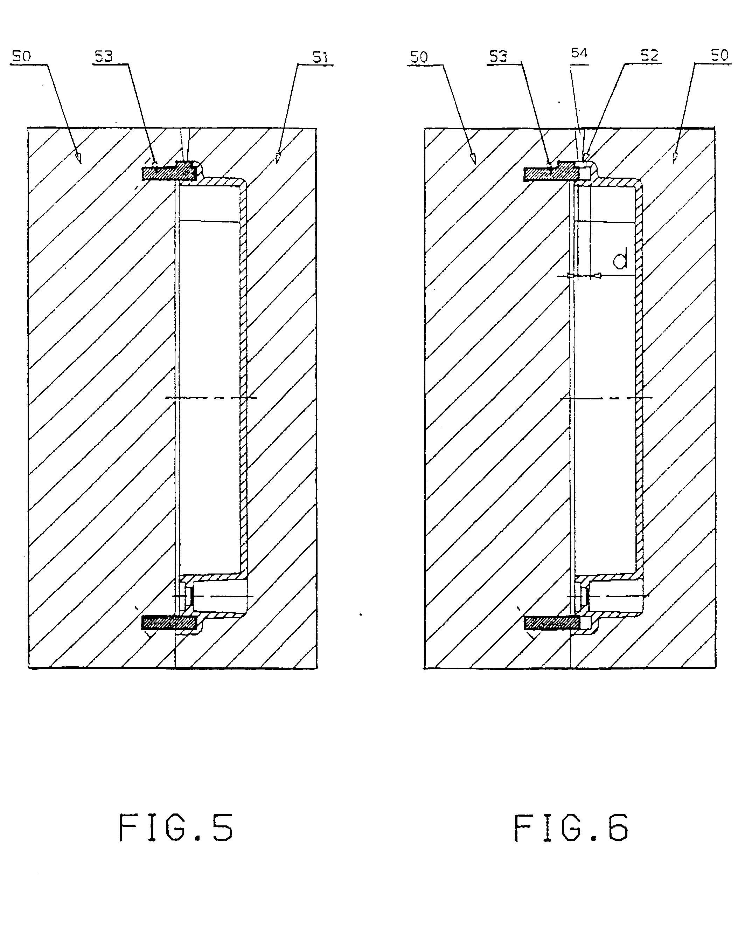

Figure 5 is a schematic cross sectional view of a mould for making the lid of a tight-seal box. Figure 5 shows: the die 50, the counterdie 51, and a mobile element 53 (belonging to the die 50) which, during the moulding step of the lid 1, shown in Figure 5, protrudes at least partially into the cavity 54 (Fig. 6) of the counterdie 51 to create the groove 7 of the lid. The mobile element 53 moreover closes at least one slot 52 (Fig. 6), made, preferably but not necessarily, at the edge of the counterdie 51.

The moulding step of the lid 1 is well known and will not be further described herein.

Figure 6 is a schematic view of the mould of Fig. 5, prepared for realising the seal 1.

For this purpose, the mobile element 53 has been pulled back from the counterdie 51 by a preset distance d. The pulling back of the mobile element 53 creates, in the groove 7 of the lid, a space whose dimensions are corresponding to those of the seal 1 to be made and simultaneously opens the aforesaid at least one slot 52, into which is injected (at preset pressure and temperature) the plastic material that forms the seal 1, which is normally softer than the material forming the lid (and the body of the tight-seal box).

The dimensions of a slot 52 are, preferably, approximately 3 x 5 mm, and in any case between 2 x 3 mm and 5 x 10 mm.

Normally, the tight-seal box is made of a thermoplastic material and the seal 1 is made of a thermoplastic elastomer, but, without departing from the scope of the invention, it is possible to make the tight-seal box and/or the seal 1 using a plastic material functionally equivalent to those indicated above as a not limiting example.

About 6 seconds (and in any case, between 4 and 10 seconds) after the end of the moulding step, the mobile element 53 is pulled back with respect to the die 50 by the aforesaid distance d (which is approximately 3 mm, and in any case between 1 and 5 mm), and the material that forms the seal 1 is injected into the aforesaid space (through the slot or slots 52) at a pressure of approximately 120 bar (and anyway between 80 and 150 bar) and at a temperature approximately 165°C (and anyway between 150°C and 175°C).

Without departing from the scope of the invention, it is possible for a skilled person to make to the seal for tight-seal box described herein all the modifications and improvements that may be suggested by normal experience and the natural evolution of techniques.

## Claims

1. One-piece seal for tight-seal box, comprising a lid and a body, said lid being fixed to said body by means of screws set in holes made in fixing bodies belonging to said lid, or to said body, said seal being positioned in a groove made around the rim of said lid, or around the top of said body of said tight-seal box, characterized in that it comprises, at each of said fixing bodies (4), a protruding area (3) positioned above said fixing body (4) and housed in a sunken area (6) made at the end of said fixing body (4).

2. Seal as per Claim 1, characterized in that said protruding areas (3) belonging to said seal (1 ) have a basically circular shape.

3. Seal as per Claim 1, characterized in that said sunken areas (6) belonging to said fixing bodies (4) are not coplanar to the bottom (8) of said groove (7).

4. Seal as per Claim 1, characterized in that said sunken areas (6) belonging to said fixing bodies (4) are coplanar to the bottom (8) of said groove (7).

5. Seal as per Claim 1, characterized in that the internal wall (9) of said groove (7) presents, at each of said fixing bodies (4), a discontinuity enabling said seal (1 ) to come out of said groove (7) to set itself over said fixing body (4).

6. Seal as per Claim 5, characterized in that said discontinuities of said internal wall (9) of said groove (7) have the same length and are symmetrical with respect to said fixing bodies (4).

7. Seal as per Claim 1, characterized in that said seal (1), said lid (2), and said body of said box are made of plastic material and made by moulding.

8. Method to make simultaneously a one-piece seal for tight-seal box and said tight-seal box comprising a lid and a body, said lid being fixed to the said body by means of screws set in holes made in fixing bodies belonging to said lid, or to said body, said seal being positioned in a groove made around the rim of said lid, or around the top of said body of said tight-seal box, said lid and said body of said tight-seal box being obtained by means of a die (50) and a counterdie (51), respectively, characterized in that, after a preset time from the end of the moulding step of said lid, or of said body of said tight-seal box, a mobile element (53) belonging to said die (50) is pulled back from said counterdie (51) by a preset distance (d), pulling back of said mobile element (53) creating in said groove (7) a space whose dimensions are corresponding to those of said seal (1) and opening at least one slot (52), the plastic material forming said seal being injected into said space through said at least one slot (52).

9. Method as per Claim 8, characterized in that said at least one slot (52) is made at the edge of said counterdie (51).

10. Method as per Claim 8, characterized in that said lid, or else said body of said box, respectively, is made of a thermoplastic material and by the fact that said seal (1) is made of a thermoplastic elastomer.

11. Method as per Claim 8, characterized in that said preset time is between 4 and 10 seconds and that said distance (d) by which said mobile element (53) is pulled back from said counterdie (51) is between 1 and 5 mm.

12. Method as per Claim 11, characterized in that said preset time is about 6 seconds and that said distance (d) by which said mobile element (53) is pulled back from said counterdie (51) is about 3 mm.

13. Method as per Claim 8, characterized in that the dimensions of said at least one slot (52) are between 2 x 3 mm and 5 x 10 mm.

14. Method as per Claim 13, characterized in that the dimensions of said at least one slot (52) are approximately 3 x 5 mm.

15. Method as per Claim 8, characterized in that said material forming said seal (1) is injected into said space through said at least one slot (52) at a pressure of between 80 and 150 bar and at a temperature between 150 and 175°C.

16. Method as per Claim 15, characterized in that said material forming said seal (1 ) is injected into said space through said at least one slot (52) at a pressure of approximately 120 bar and at a temperature of approximately 165°C.
